# DEMANDE DE BREVET EUROPEEN

(11) **EP 2 073 377 A1**
(43) Date de publication de la demande: **24.06.2009**
(21) Numéro de dépôt: 07150135.7
(22) Date de dépôt: 19.12.2007
(51) Int. Cl.: H03B 5/36

(54) **Circuit oscillateur à quartz à polarisation active faible consommation**

(71) Demandeur: The Swatch Group Research and Development Ltd., 2074 Marin (CH)
(72) Inventeur: Casagrande, Arnaud, 2068 Hauterive (CH)
(74) Mandataire: Ravenel, Thierry Gérard Louis

(57) **Abrégé**

Le circuit oscillateur à quartz comprend un inverseur composé de deux transistors complémentaires PMOS et NMOS (P1, N1) montés en série avec une source de courant (4) entre deux bornes d'une source de tension d'alimentation pour définir une branche active. Une borne de source du transistor PMOS (P1) est reliée à la source de courant, alors qu'une borne de source de l'autre transistor NMOS (N1) est reliée à une borne de masse. Des bornes de drain des transistors sont reliées en sortie à une première électrode (X_{OUT}) du quartz (3), alors que des bornes de grille desdits transistors étant reliées en entrée à une seconde électrode (X_{IN}) du quartz. Un premier condensateur de déphasage (C₁) est relié à la première électrode du quartz, alors qu'un second condensateur (C₂) est relié à la seconde électrode du quartz. Le circuit oscillateur comprend un moyen de polarisation active (2) disposé entre les bornes de drain et les bornes de grille des transistors de l'inverseur. Ce moyen de polarisation peut être un amplificateur opérationnel à transconductance monté en suiveur et ayant une impédance de valeur suffisamment grande pour ne pas dégrader la transconductance de la branche active pour la génération d'une oscillation au niveau du quartz.

## Description

L'invention concerne un circuit oscillateur à quartz à polarisation active faible consommation, notamment pour une utilisation horlogère.

Le circuit oscillateur peut comprendre un inverseur composé de deux transistors complémentaires MOS montés en série avec une source de courant entre deux bornes d'une source de tension d'alimentation pour définir une branche active. Une borne de source d'un des transistors MOS est reliée à la source de courant, alors qu'une borne de source de l'autre transistor est reliée à une des bornes de la source de tension d'alimentation. Les bornes de drain des transistors NMOS et PMOS sont reliées en sortie à une première électrode du quartz, alors que les bornes de grille desdits transistors en entrée sont reliées à une seconde électrode du quartz. Traditionnellement un premier condensateur de déphasage est relié à la première électrode du quartz, alors qu'un second condensateur ajustable est relié à la seconde électrode du quartz.

Un tel circuit oscillateur est notamment décrit dans l'état de la technique par le brevet CH 623 450, dans lequel il est également prévu une résistance de polarisation disposée entre les grilles et les drains des transistors de l'inverseur. De par ce montage, une oscillation en tension au niveau du quartz est établie pour produire un signal d'oscillation à fréquence déterminée par la première électrode de sortie du quartz.

Pour réaliser un circuit oscillateur à faible consommation en réduisant le courant dans la branche active de l'oscillateur, il est nécessaire d'avoir une résistance de polarisation de grande valeur. Cette résistance de polarisation de grande valeur doit notamment être choisie pour ne pas détruire la résistance négative nécessaire, qui est générée par l'inverseur et le courant qui le traverse pour l'entretien de l'oscillation au niveau du quartz. Lors d'une intégration d'un tel circuit oscillateur à faible consommation dans un substrat de silicium, la réalisation d'une résistance de grande valeur peut être un problème, car elle occupe une place importante dans le circuit intégré. Ceci constitue donc un inconvénient d'un tel circuit oscillateur à faible consommation.

L'amplitude de l'oscillation au niveau du quartz peut être également maintenue par une source de courant adaptable commandée par une unité de régulation. Une forme d'exécution d'une telle unité de régulation est décrite par exemple dans l'article intitulé "Quartz oscillators for watches" de Eric A. Vittoz, publié dans les actes du dixième Congrès International de Chronométrie, Genève, septembre 1979, vol. 3, pages 131 à 140.

L'invention a donc pour but de pallier aux inconvénients de l'état de la technique en fournissant un circuit oscillateur à quartz faible consommation qui est à polarisation active facile à intégrer tout en garantissant une grande impédance de polarisation sans dégrader l'oscillation au niveau du quartz.

A cet effet, l'invention concerne un circuit oscillateur à quartz cité ci-devant qui comprend les caractéristiques définies dans la revendication indépendante 1.

Des formes d'exécution particulières du circuit oscillateur à quartz sont définies dans les revendications dépendantes 2 à 8.

Un avantage du circuit oscillateur selon l'invention est qu'il comprend un moyen de polarisation active de grande impédance, qui est disposé en partie entre les bornes de grille et drain des transistors de l'inverseur. Ce moyen de polarisation peut être réalisé avec des composants électroniques simples et faciles à intégrer. Lors de la mise en fonction du circuit oscillateur, ce moyen de polarisation active permet d'opérer une polarisation initiale des grilles des transistors MOS de l'inverseur pour la génération d'une oscillation au niveau du quartz. Une fois l'oscillation stabilisée, la transconductance effective de la branche active, générant une résistance négative en parallèle du quartz, est primordiale pour le maintien de l'oscillation au niveau du quartz, sans être dégradée par la haute impédance du moyen de polarisation. Ainsi l'impédance de polarisation est entièrement compensée par la transconductance totale de la branche active pour assurer un entretien de l'oscillation du quartz.

Un avantage d'utiliser un amplificateur opérationnel à transconductance, qui est configuré en suiveur de tension comme moyen de polarisation, est qu'il permet de polariser activement la partie oscillateur du circuit oscillateur avec une impédance très élevée. Ce suiveur permet de fournir un courant de sortie lors de la génération de l'oscillation au niveau du quartz. De plus comme l'oscillateur est composé d'un quartz dans un montage Colpitts, le condensateur parasite du quartz, monté dans une configuration Miller, permet de stabiliser entièrement l'amplificateur sans devoir monter d'autres condensateurs dans ce but dans le circuit oscillateur.

Un avantage du circuit oscillateur est qu'il peut comprendre une pseudo-résistance comme moyen de polarisation active. Cette pseudo-résistance peut être réalisée au moyen d'un transistor NMOS, dont la borne de source est reliée aux bornes de grille des transistors de l'inverseur, et la borne de drain est reliée aux bornes de drain des transistors de l'inverseur. Cette pseudo-résistance est polarisée sur sa borne de grille par une autre source de courant de faible valeur, qui est également reliée aux bornes de drain et grille d'un autre transistor NMOS, dont la borne de source est reliée aux bornes de drain des transistors de l'inverseur. En phase d'oscillation, le faible courant de cette autre source de courant s'ajoute au courant fourni par la source de courant de polarisation de la branche active dans le transistor NMOS de l'inverseur.

Le courant de polarisation de la branche active, et le faible courant d'alimentation du moyen de polarisation peuvent être avantageusement adaptés dans une unité de régulation sur la base du niveau d'amplitude détecté au niveau de la première électrode du quartz.

Les buts, avantages et caractéristiques du circuit oscillateur à quartz apparaîtront mieux dans la description suivante sur la base de formes d'exécution non limitatives illustrées par les dessins sur lesquels :
la figure 1 représente une première forme d'exécution simplifiée de la partie oscillateur du circuit oscillateur à quartz selon l'invention,
la figure 2 représente un mode de réalisation de l'amplificateur utilisé comme moyen de polarisation de la figure 1, pour un circuit oscillateur à quartz selon l'invention,
la figure 3 représente une seconde forme d'exécution simplifiée de la partie oscillateur du circuit oscillateur à quartz selon l'invention,
la figure 4 représente une unité de régulation du courant de polarisation de la partie oscillateur du circuit oscillateur à quartz selon l'invention, et
la figure 5 représente un graphe du courant de polarisation de la partie oscillateur en fonction de l'amplitude d'oscillation détectée du circuit oscillateur à quartz selon l'invention.

Dans la description suivante, tous les éléments du circuit oscillateur à quartz qui sont bien connus de l'homme du métier dans ce domaine technique ne seront relatés que de manière simplifiée. Il est fait référence principalement à un circuit oscillateur à quartz susceptible de fournir des signaux d'horloge notamment pour une utilisation horlogère.

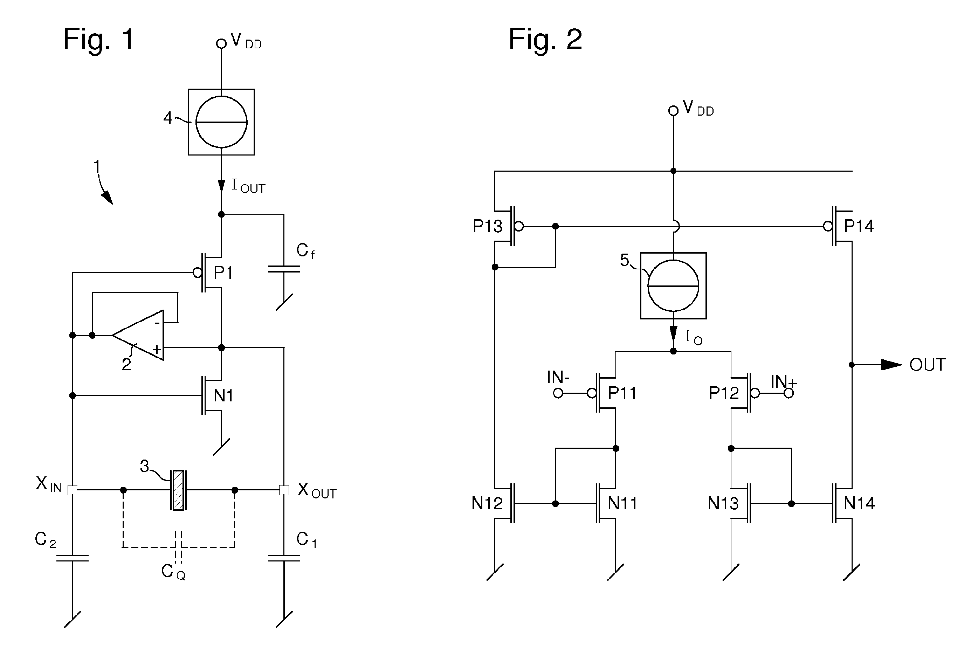

A la figure 1, il est représenté une première forme d'exécution de la partie oscillateur 1 du circuit oscillateur à quartz. Cette partie oscillateur 1 du circuit oscillateur comprend un inverseur composé de deux transistors complémentaires MOS N1 et P1 montés en série avec une source de courant 4 entre une borne positive V_{DD} et une borne de masse d'une source de tension continue d'alimentation non représentée. Cet agencement en série de l'inverseur avec la source de courant définit la branche active de l'oscillateur.

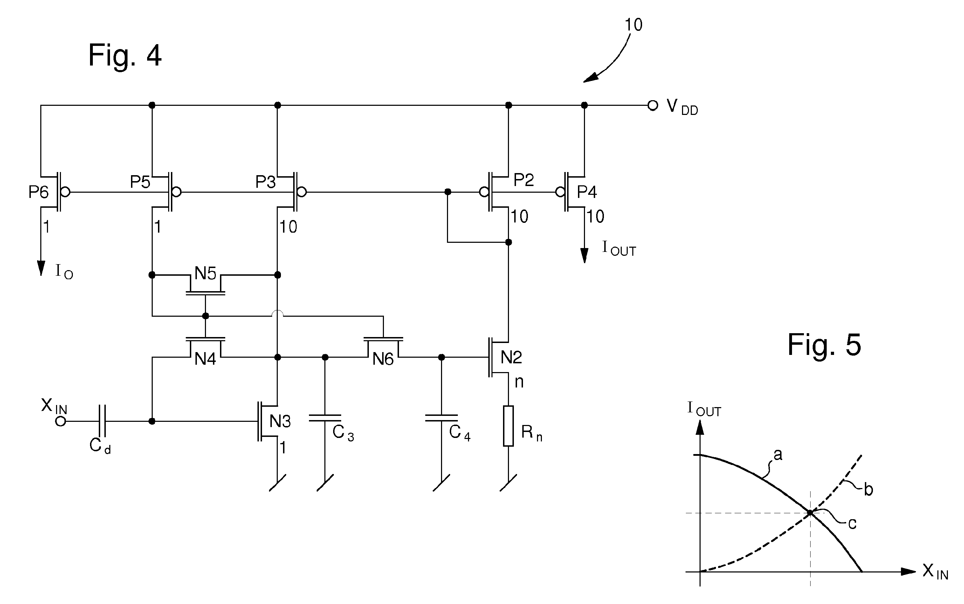

Une borne de source du premier transistor PMOS P1 est reliée à la source de courant 4, qui est reliée à la borne positive V_{DD} de la source de tension. Une borne de source du second transistor NMOS N1 est reliée à la borne de masse de la source de tension d'alimentation. Les bornes de drain des deux transistors P1 et N1 sont reliées ensemble à une première électrode du quartz 3, pour définir une borne de sortie X_{OUT} du circuit oscillateur. Les bornes de grille des deux transistors P1 et N1 sont par contre reliées ensemble en entrée à une seconde électrode du quartz 3 pour définir une borne d'entrée X_{IN}. Cette borne d'entrée X_{IN} est utilisée pour la détection d'amplitude d'oscillation par l'intermédiaire d'une unité de régulation expliquée ci-après en référence à la figure 4.

Un condensateur de filtrage C_{f} de valeur adaptée est relié entre la borne de source du premier transistor PMOS P1 de l'inverseur et la borne de masse. Ce condensateur de filtrage permet de filtrer la tension d'oscillation au niveau de la source de courant 4, qui est à haute impédance. Grâce à ce condensateur qui fixe la borne de source du premier transistor P1, cela permet de rendre actif ce premier transistor au même titre que le second transistor NMOS N1, dont la borne de source est directement reliée à la borne de masse. Ces deux transistors P1 et N1 agissent en combinaison dans la branche active pour assurer un entretien de l'oscillation au niveau du quartz 3 avec un courant bien défini par la source de courant 4.

L'oscillateur est du type Colpitts avec un premier condensateur de déphasage C₁, qui est relié entre la première électrode X_{OUT} du quartz 3 et la masse, et un second condensateur ajustable C₂, qui est relié entre la seconde électrode X_{IN} du quartz et la masse. Ce quartz ou résonateur à quartz 3 est composé d'un condensateur parasite C_{Q}, montré en traits interrompus sur la figure 1, qui est en parallèle avec des éléments en série non représentés, qui sont une inductance, une résistance et un autre condensateur. Ce condensateur parasite peut être de valeur proche de 1 à 1.5 pF pour un quartz horloger susceptible d'osciller à une fréquence de l'ordre de 32.768 kHz.

Comme le circuit oscillateur à quartz est destiné à fonctionner à faible consommation, le courant de polarisation I_{OUT} de la branche active est de faible valeur, par exemple de l'ordre de 30 nA ou inférieure. Ceci conduit à une transconductance gm dans la branche active critique pour des courants extrêmement faibles. Il est donc nécessaire de prévoir un moyen de polarisation entre les bornes de grille et drain des transistors complémentaires MOS P1, N1 de l'inverseur, qui possède une impédance aussi haute que possible. Cette impédance doit être suffisante, par exemple de l'ordre de 100 MΩ ou supérieure, pour ne pas trop dégrader la transconductance effective de la branche active afin d'assurer une oscillation entretenue au niveau du quartz.

Le moyen de polarisation active est dans cette première forme d'exécution un amplificateur opérationnel à transconductance OTA 2 (Operational Transconductance Amplifier en terminologique anglaise) monté en suiveur de tension. La borne positive d'entrée de cet amplificateur est reliée aux bornes de drain du premier transistor PMOS P1 et du second transistor NMOS N1, et à la première électrode X_{OUT} du quartz 3. La borne négative d'entrée est reliée à la borne de sortie de l'amplificateur et aux bornes de grille des transistors P1 et N1, ainsi qu'à la seconde électrode X_{IN} du quartz 3.

Comme indiqué précédemment, ce moyen de polarisation active doit avoir une impédance suffisante pour que la consommation soit dominée principalement par le quartz. Ceci permet d'assurer un entretien de l'oscillation au niveau du quartz. Une fois l'oscillation stabilisée, la tension continue en entrée et la tension continue en sortie de cet amplificateur OTA monté en suiveur de tension, sont égales. De ce fait, le signal d'oscillation sur l'électrode de sortie X_{OUT} est déphasé de 180° du signal d'oscillation sur l'électrode d'entrée X_{IN}.

En utilisant un tel amplificateur opérationnel à transconductance 2, il est en principe nécessaire que sa fréquence de coupure soit inférieure à la fréquence d'oscillation du quartz 3. Mais dans le cas d'une oscillation à fréquence de l'ordre de 32 kHz opérée par un quartz horloger, le montage en suiveur d'un amplificateur OTA 2 entre les bornes de drain et grille des transistors P1 et N1 peut conduire à une instabilité. Une oscillation à fréquence parasite non désirée peut donc être générée par un tel amplificateur OTA 2 alimenté par un faible courant, par exemple de l'ordre de 3 nA ou inférieur.

Cependant comme le quartz 3 comprend un condensateur parasite C_{Q}, la mise en parallèle de ce condensateur, dans une configuration du type Miller, avec l'amplificateur OTA 2 monté en suiveur permet de stabiliser totalement cet agencement. Dans cette configuration du type Miller, la valeur capacitive de ce condensateur parasite est multipliée par le gain très important de boucle effectif en sortie de la branche active. Ceci revient naturellement à fortement diminuer la fréquence de coupure de l'amplificateur OTA monté en suiveur avec ce condensateur parasite en parallèle en ayant une marge de phase suffisante, et ainsi stabiliser complètement le suiveur OTA. Grâce à cela, il n'est pas nécessaire de monter d'autres condensateurs de stabilisation de cet amplificateur, ce qui est un avantage considérable de la combinaison du quartz et du moyen de polarisation active constitué par ce suiveur OTA.

Un mode de réalisation d'un tel amplificateur opérationnel à transconductance OTA utilisé comme moyen de polarisation active du circuit oscillateur est représenté à la figure 2. Cet amplificateur comprend tout d'abord une paire différentielle de transistors PMOS P11 et P12, dont la borne de source de chaque transistor est reliée à une source de courant 5, qui est reliée à une borne positive V_{DD} de la source de tension d'alimentation. La borne de grille du premier transistor d'entrée PMOS P11 constitue la borne d'entrée négative IN- de l'amplificateur, alors que la borne de grille du second transistor d'entrée PMOS P12 constitue la borne d'entrée positive IN+ de l'amplificateur.

La borne de drain du premier transistor d'entrée P11 est reliée à des bornes de drain et grille d'un premier transistor NMOS N11 d'un premier miroir de courant NMOS. La borne de grille de ce premier transistor N11 est reliée à une borne de grille d'un second transistor identique NMOS N12 du premier miroir de courant NMOS. Les bornes de source des premier et second transistors N11 et N12 sont reliées à la borne de masse. Le premier transistor NMOS N11 est agencé pour miroiter le courant le traversant dans le second transistor NMOS N12.

La borne de drain du second transistor NMOS N12 du premier miroir de courant NMOS est reliée à des bornes de drain et grille d'un premier transistor PMOS P13 d'un miroir de courant PMOS. La borne de grille de ce premier transistor PMOS P13 est reliée à une borne de grille d'un second transistor identique PMOS P14 du miroir de courant PMOS. Les bornes de source des premier et second transistors P13, P14 du miroir de courant PMOS sont reliées à la borne positive V_{DD} de la source de tension d'alimentation. Le premier transistor PMOS P13 est agencé pour miroiter le courant le traversant, provenant du second transistor NMOS N12, dans le second transistor PMOS P14, dont la borne de drain est reliée à la borne de sortie OUT de l'amplificateur.

La borne de drain du second transistor d'entrée P12 est reliée à des bornes de drain et grille d'un premier transistor NMOS N13 d'un second miroir de courant NMOS. La borne de grille de ce premier transistor N13 est reliée à une borne de grille d'un second transistor identique NMOS N14 du second miroir de courant NMOS. Les bornes de source des premier et second transistors N13 et N14 sont reliées à la borne de masse. Le premier transistor NMOS N13 est agencé pour miroiter le courant le traversant dans le second transistor NMOS N14. La borne de drain du transistor N14 est reliée directement à la borne de drain du transistor P14 et à la borne de sortie OUT de l'amplificateur.

Lorsque la borne d'entrée négative IN- du premier transistor d'entrée P11 est polarisée par une tension inférieure à la tension polarisant la borne d'entrée positive IN+ du second transistor d'entrée P12, le courant de la source de courant 5 passe principalement entre les bornes de source et drain du premier transistor P11. De ce fait, ce courant est miroité par le premier miroir NMOS et le miroir PMOS afin de tirer la sortie OUT en courant de l'amplificateur vers le haut. Par contre dans le cas inverse où la borne d'entrée négative IN- est polarisée par une tension supérieure à la tension polarisant la borne d'entrée positive IN+, le courant de la source de courant 5 passe principalement entre les bornes de source et drain du second transistor P12. Ainsi, le courant miroité par le second miroir de courant NMOS permet de tirer la sortie OUT en courant de l'amplificateur vers le bas.

La consommation en courant de l'amplificateur opérationnel à transconductance est relativement faible. Cette consommation en moyenne est de l'ordre de deux fois la valeur du courant I₀ de la source de courant 5, qui peut être de l'ordre de 3 nA ou inférieur. Ce courant de la source de courant 5 peut également être adapté en fonction de l'amplitude d'oscillation détectée au niveau du quartz au moyen d'une unité de régulation expliquée ci-après en référence à la figure 4. Cette source de courant est réalisée dans ladite unité de régulation.

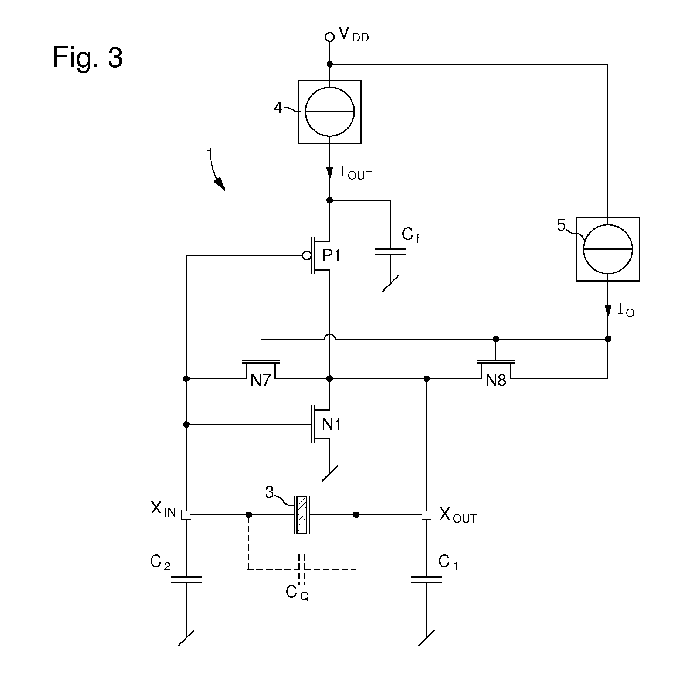

A la figure 3, il est représenté une seconde forme d'exécution de la partie oscillateur 1 du circuit oscillateur à quartz. Il est à noter que les mêmes éléments du circuit oscillateur décrits ci-devant dans la figure 1 portent des signes de référence identiques. De ce fait par simplification, il ne sera pas répété la description de chacun de ces éléments à la figure 3.

La différence essentielle de cette seconde forme d'exécution est relative au moyen de polarisation active disposé en partie entre les bornes de drain et grille des transistors complémentaires MOS P1 et N1 de l'inverseur. Ce moyen de polarisation active comprend essentiellement une pseudo-résistance réalisée au moyen d'un transistor NMOS N7. La borne de source de ce transistor N7 est reliée aux bornes de grille des transistors P1, N1 de l'inverseur, et la borne de drain du transistor N7 est reliée aux bornes de drain des transistors P1, N1 de l'inverseur.

La borne de grille du transistor N7 en pseudo-résistance est reliée aux bornes de drain et grille d'un transistor de polarisation NMOS N8 afin de recevoir un courant I₀ d'une source de courant 5 réalisée dans l'unité de régulation. Cette source de courant 5 est reliée à la borne positive V_{DD} d'une source de tension d'alimentation non représentée. La borne de source du transistor NMOS N8 est reliée aux bornes de drain des transistors P1, N1 de l'inverseur. En phase d'oscillation, le faible courant I₀ de la source de courant 5 s'ajoute au courant I_{OUT} fourni par la source de courant de polarisation 4 de la branche active dans le transistor NMOS N1 de l'inverseur.

Cette seconde forme d'exécution avec la pseudo-résistance N7 ne permet pas de fournir une amplitude d'oscillation au niveau du quartz 3 aussi importante que la première forme d'exécution. Ceci est dû à l'impédance de la pseudo-résistance N7, qui chute et dégrade la transconductance effective de la branche active lorsque le niveau de tension sur la seconde électrode X_{IN} en phase d'oscillation s'abaisse d'une trop grande valeur par rapport au niveau de tension sur la première électrode X_{OUT}.

A la figure 4, il est représenté une unité de régulation 10 du courant de polarisation de la partie oscillateur du circuit oscillateur à quartz. Cette unité de régulation est reliée par l'intermédiaire d'un condensateur de détection C_{d} à la seconde électrode d'entrée X_{IN} du quartz pour la détection d'amplitude d'oscillation. Ce condensateur de détection est de faible valeur capacitive, par exemple de l'ordre de 0.5 pF.

L'unité de régulation 10 comprend principalement un miroir de courant PMOS relié à un miroir de courant NMOS pour la réalisation d'au moins une source de courant proportionnelle à la température absolue PTAT (Proportional to Absolute Temperature en terminologie anglaise). Cette source de courant doit pouvoir être adaptée en fonction du niveau d'amplitude d'oscillation sur le quartz détecté par l'intermédiaire du condensateur C_{d}.

Pour ce faire, le miroir NMOS est composé d'un premier transistor unitaire NMOS N3 indiqué avec un indice 1. La borne de source du transistor N3 est reliée à la borne de masse. La borne de grille de ce transistor N3 est reliée au condensateur de détection C_{d}. Les bornes de drain et grille de ce premier transistor unitaire N3 sont reliées ensemble par l'intermédiaire d'une première pseudo-résistance, qui est réalisée par un transistor NMOS N4 entre ses bornes de drain et source. L'impédance de cette pseudo-résistance est de grande valeur tout en garantissant un écart en tension entre la borne de drain et la borne de grille du premier transistor N3 proche de 0 V.

La borne de drain du premier transistor unitaire NMOS N3 est reliée à la borne de grille d'un second transistor NMOS N2 du miroir de courant NMOS par l'intermédiaire d'une seconde pseudo-résistance, qui est réalisée par un transistor NMOS N6 entre ses bornes de drain et source. L'impédance de cette seconde pseudo-résistance est également de grande valeur. La dimension de ce second transistor NMOS N2 est n fois plus grande que la dimension du premier transistor unitaire N3, c'est-à-dire que la largeur de grille de ce second transistor N2 peut être n fois plus grande que la largeur de grille du premier transistor N3. Le nombre entier n peut être par exemple égal à 4. La borne de source du second transistor NMOS N2 est reliée à la borne de masse par l'intermédiaire d'une résistance Rₙ, par exemple de l'ordre de 1 MΩ. Ceci permet de définir la valeur du courant traversant les deux transistors NMOS N3 et N2 par combinaison avec le miroir de courant PMOS pour la réalisation de la source de courant PTAT.

Il peut être prévu un premier condensateur de stabilisation C₃ relié entre la borne de drain du premier transistor NMOS N3 et la borne de masse, et un second condensateur de stabilisation C₄ relié entre la borne de grille du second transistor NMOS N2 et la borne de masse. Chacun de ces condensateurs C₃, C₄ peut avoir une valeur capacitive de l'ordre de 5 pF par exemple.

Le second transistor NMOS N2 commande le miroir de courant PMOS. La borne de drain du second transistor N2 est reliée directement aux bornes de drain et grille d'un premier transistor PMOS P2, dont la borne de source est reliée à la borne positive V_{DD} d'une source de tension d'alimentation. Un second transistor PMOS P3 du miroir de courant PMOS de taille équivalente au premier transistor P2 a sa borne de grille reliée à la borne de grille du premier transistor PMOS P2. La borne de source de ce second transistor P3 est reliée à la borne positive V_{DD}, alors que sa borne de drain est reliée directement à la borne de drain du premier transistor NMOS N3 pour fermer la boucle PTAT de génération de courants définis.

Un troisième transistor PMOS P5 du miroir de courant PMOS permet de polariser les pseudo-résistances réalisées par les transistors NMOS N4 et N6. Pour ce faire, la borne de drain du transistor PMOS P5 est reliée aux bornes de grille des transistors N4 et N6. La borne de source de ce troisième transistor PMOS P5 est reliée à la borne positive V_{DD} de la source de tension d'alimentation, alors que sa borne de grille est reliée à la borne de grille des transistors P2 et P3.

Ce troisième transistor PMOS P5 est de taille inférieure aux premier et second transistors PMOS P2 et P3. Ce transistor P5 portant l'indice 1 peut être de taille 10 fois inférieure à celle des transistors P2 et P3. De ce fait, le courant miroité dans ce troisième transistor PMOS P5 est 10 fois inférieur au courant traversant les premier et second transistors P2 et P3. Dans le cas où le courant dans chaque transistor P2 et P3 peut être de l'ordre de 30 nA ou inférieur, le courant dans le troisième transistor P5 peut donc être de l'ordre de 3 nA ou inférieur.

La borne de drain du troisième transistor PMOS P5 est reliée également aux bornes de drain et grille d'un transistor de polarisation NMOS N5, dont la borne de source est reliée dans une branche active aux bornes de drain des transistors P3 et N3. Le courant miroité dans ce troisième transistor PMOS P5 va passer principalement entre les bornes de drain et source du transistor de polarisation N5 afin d'être injecté dans la branche active constituée par les transistors P3 et N3. Ainsi le courant traversant le transistor NMOS N3 comprend le courant provenant du transistor PMOS P3 et celui du transistor PMOS P5.

L'agencement des pseudo-résistances réalisées par les transistors N4 et N6, et du transistor de polarisation NMOS N5 permet d'avoir un bon appariement de ces transistors avec des tensions grille-source égales. Le potentiel de grille de chacun de ces transistors est égal et ainsi bien défini.

Un quatrième transistor PMOS P4 du miroir de courant PMOS permet de fournir par sa borne de drain le courant de polarisation I_{OUT} de la branche active de la partie oscillateur du circuit oscillateur. La borne de grille du transistor P4 est reliée à la borne de grille des transistors P2 et P3, alors que sa borne de source est reliée à la borne positive V_{DD} de la source de tension d'alimentation. Ce quatrième transistor P4 est de taille équivalente définie par l'indice 10 aux premier et second transistors PMOS P2 et P3.

Un cinquième transistor PMOS P6 du miroir de courant PMOS permet de fournir par sa borne de drain le courant de polarisation I₀ pour le moyen de polarisation, qui peut être un suiveur OTA ou comprendre une pseudo-résistance. La borne de grille du transistor P6 est reliée à la borne de grille des transistors P2, P3 et P4, alors que sa borne de source est reliée à la borne positive V_{DD} de la source de tension d'alimentation. Ce cinquième transistor P6 peut être réalisé de taille équivalente au troisième transistor PMOS P5 par exemple 10 fois inférieure aux transistors PMOS P2, P3 et P4 pour fournir un courant de polarisation I₀. Ce courant de polarisation I₀ peut être de valeur 10 fois inférieure au courant de polarisation de la branche active de la partie oscillateur.

Bien entendu, la taille du transistor PMOS P6 peut être choisie inférieure à 10 fois la taille des transistors P2, P3, P4 pour diminuer encore le courant de polarisation I₀ par rapport au courant de la branche active de l'inverseur I_{OUT}.

Comme on peut le remarquer sommairement sur le graphe de la figure 5, la valeur du courant de polarisation I_{OUT} de la branche active de la partie oscillateur doit diminuer plus l'amplitude de l'oscillation détectée en entrée du quartz sur la borne X_{IN} augmente.

La courbe a sur cette figure 5 représente la fonction de transfert de l'amplitude d'oscillation mesurée X_{IN} par rapport au courant de sortie I_{OUT} de l'unité de régulation. La courbe b représente la fonction de transfert du courant de la partie oscillateur par rapport à l'amplitude d'oscillation sur l'électrode X_{IN}. Une fois l'oscillation stabilisée, l'intersection des courbes a et b représente un optimum au point c où la valeur du courant de polarisation I_{OUT} est adaptée par rapport à l'amplitude d'oscillation stabilisée au niveau de X_{IN}.

Le circuit oscillateur à quartz décrit ci-devant peut être avantageusement réalisé sous forme intégrée à l'exception du quartz 3 dans un substrat de silicium normalement dopé P dans une technologie CMOS à 0.18 µm. Ceci permet d'obtenir un circuit oscillateur à polarisation active faible consommation.

A partir de la description qui vient d'être faite, plusieurs variantes du circuit oscillateur à quartz peuvent être conçues par l'homme du métier sans sortir du cadre de l'invention définie par les revendications. Les éléments de la partie oscillateur peuvent être montés inversement entre la borne positive et la borne de masse d'une source de tension d'alimentation. La source de courant de polarisation peut ainsi être reliée entre la borne de source du transistor NMOS de l'inverseur et la borne de masse, alors que la borne de source du transistor PMOS est reliée à la borne positive. Dans ce cas de figure, l'unité de régulation doit être configurée inversement pour produire les courants de polarisation de la partie oscillateur.

## Revendications

1. Circuit oscillateur à quartz comprenant un inverseur composé de deux transistors complémentaires MOS (P1, N1) montés en série avec une source de courant (4) entre deux bornes d'une source de tension d'alimentation pour définir une branche active, une borne de source d'un premier transistor MOS (P1) est reliée à la source de courant, alors qu'une borne de source du second transistor MOS (N1) est reliée à une des bornes de la source de tension d'alimentation, des bornes de drain des deux transistors de l'inverseur étant reliées ensemble en sortie à une première électrode (X_{OUT}) du quartz (3), alors que des bornes de grille desdits transistors de l'inverseur étant reliées ensemble en entrée à une seconde électrode (X_{IN}) du quartz, un premier condensateur de déphasage (C₁) étant relié à la première électrode du quartz, alors qu'un second condensateur (C₂) étant relié à la seconde électrode du quartz, **caractérisé en ce que** le circuit oscillateur comprend un moyen de polarisation active (2) disposé entre les bornes de drain et les bornes de grille des transistors de l'inverseur, ledit moyen de polarisation ayant une impédance de valeur suffisamment grande pour ne pas dégrader la transconductance de la branche active pour la génération d'une oscillation au niveau du quartz.

2. Circuit oscillateur à quartz selon la revendication 1, **caractérisé en ce que** le moyen de polarisation active est un amplificateur opérationnel à transconductance (2) monté en suiveur de tension entre les bornes de drain et les bornes de grille des transistors MOS (P1, N1) de l'inverseur.

3. Circuit oscillateur à quartz selon la revendication 2, **caractérisé en ce qu'**une borne d'entrée positive de l'amplificateur opérationnel à transconductance est reliée aux bornes de drain des transistors complémentaires MOS de l'inverseur et à la première électrode (X_{OUT}) du quartz (3), et **en ce qu'**une borne d'entrée négative de l'amplificateur est reliée à une borne de sortie de l'amplificateur, aux bornes de grille des transistors MOS de l'inverseur et à la seconde électrode (X_{IN}) du quartz.

4. Circuit oscillateur à quartz selon la revendication 1, **caractérisé en ce que** le moyen de polarisation active est composé d'une pseudo-résistance réalisée par un transistor MOS (N7), dont des bornes de drain et source sont reliées d'une part aux bornes de grille des transistors complémentaires MOS (P1, N1) de l'inverseur, et d'autre part aux bornes de drain des transistors complémentaires MOS.

5. Circuit oscillateur à quartz selon la revendication 4, **caractérisé en ce que** le moyen de polarisation active comprend également un transistor MOS de polarisation (N8) de même type que le transistor MOS en pseudo-résistance (N7), une borne de source du transistor de polarisation étant reliée aux bornes de drain des transistors MOS de l'inverseur, et des bornes de drain et grille du transistor de polarisation étant reliées à une borne de grille du transistor MOS (N7) en pseudo-résistance et à une source de courant de polarisation (5) pour polariser le transistor MOS en pseudo-résistance et le transistor de polarisation, qui est traversé par le courant de polarisation.

6. Circuit oscillateur à quartz selon l'une des revendications précédentes, **caractérisé en ce qu'**il comprend une unité de régulation (10), qui est reliée par l'intermédiaire d'un condensateur de détection (C_{d}) à la seconde électrode (X_{IN}) du quartz (3) pour détecter le niveau d'amplitude d'oscillation, et **en ce que** la source de courant (4) de la branche active et une source de courant de polarisation (5) du moyen de polarisation active sont réalisées dans l'unité de régulation, la valeur du courant de chaque source de courant étant adaptée en fonction du niveau d'amplitude d'oscillation détecté.

7. Circuit oscillateur à quartz selon revendication 6, pour lequel une borne de source du premier transistor PMOS (P1) est reliée à la source de courant (4) de la branche active, qui est reliée à la borne positive (V_{DD}) d'une source de tension, et pour lequel une borne de source du second transistor NMOS (N1) est reliée à la borne de masse de la source de tension, **caractérisé en ce que** l'unité de régulation comprend un miroir de courant PMOS (P2, P3) relié du côté de la borne positive de la source de tension, combiné avec un miroir de courant NMOS (N2, N3) relié du côté de la borne de masse de la source de tension, et une résistance (Rₙ) pour définir la valeur de courant dans une boucle de génération d'au moins une source de courant proportionnelle à la température absolue, **en ce que** le miroir de courant NMOS comprend un premier transistor unitaire NMOS (N3), dont une borne de grille est reliée au condensateur de détection (C_{d}) et à une borne de drain du premier transistor par l'intermédiaire d'une première pseudo-résistance (N4), la borne de drain du premier transistor étant reliée par l'intermédiaire d'une seconde pseudo-résistance (N6) à une borne de grille d'un second transistor NMOS (N2) de dimension n fois plus grande que le premier transistor NMOS, la borne de source du second transistor étant reliée à la résistance, **en ce que** le miroir de courant PMOS comprend un premier transistor PMOS (P2), dont des bornes de drain et grille sont reliées à une borne de drain du second transistor NMOS, un second transistor PMOS (P3) de taille équivalente au premier transistor PMOS ayant une borne de grille reliée à la borne de grille du premier transistor PMOS (P2) et une borne de drain reliée directement à la borne de drain du premier transistor NMOS (N3) pour fermer la boucle de génération de courants définis, et **en ce que** le miroir de courant PMOS comprend un transistor PMOS (P4) comme source de courant (I_{OUT}) de la branche active de la partie oscillateur, ce transistor PMOS étant de taille équivalente aux premier et second transistors PMOS, et un autre transistor PMOS (P6) comme source de courant de polarisation (I₀) du moyen de polarisation active, la taille de cet autre transistor PMOS étant m fois inférieure aux autres transistors PMOS, notamment de taille 10 fois inférieure.

8. Circuit oscillateur à quartz selon la revendication 7, **caractérisé en ce que** le miroir de courant PMOS comprend un troisième transistor PMOS (P5) de taille inférieure aux premier et second transistors PMOS du miroir pour polariser les première et seconde pseudo-résistances réalisées chacune par un transistor NMOS (N4, N6) entre des bornes de drain et source, une borne de drain du troisième transistor PMOS étant reliée aux bornes de grille des transistors NMOS en pseudo-résistance, et **en ce que** la borne de drain du troisième transistor PMOS (P5) est reliée également aux bornes de drain et grille d'un transistor de polarisation NMOS (N5), dont la borne de source est reliée dans une branche active aux bornes de drain du premier transistor NMOS (N3) et du second transistor PMOS (P3) pour le passage du courant miroité dans le troisième transistor PMOS (P5), ledit transistor de polarisation et les transistors en pseudo-résistance étant appariés avec des tensions grille-source égales.
